# EUROPEAN PATENT SPECIFICATION

(11) **EP 0 451 389 B1**
(45) Date of publication and mention of the grant of the patent: **01.02.1995**
(21) Application number: 90303909.7
(22) Date of filing: 11.04.1990
(51) Int. Cl.: H01L 29/792, H01L 21/3115

(54) **Nonvolatile semiconductor memory and method of making same**
Nichtflüchtiger Halbleiterspeicher und Verfahren zu seiner Herstellung
Mémoire rémanente semi-conductrice et sa méthode de fabrication

(43) Date of publication of application: 16.10.1991
(73) Proprietor: MATSUSHITA ELECTRIC INDUSTRIAL CO., LTD., Kadoma-shi, Osaka-fu, 571 (JP)
(72) Inventor: Ohzone, Takashi, Moriguchi-shi, Osaka (JP); Hori, Takashi, Hirakata-shi, Osaka (JP)
(74) Representative: Senior, Alan Murray

(56) References cited:
- US-A- 3 649 884
- IEEE TRANSACTIONS ON ELECTRON DEVICES, vol. ED-34, no. 11, November 1987, pages 2372-2373; A. KALNITSKY et al.: "Memory effect and enhanced conductivity in Si-implanted thermally grown SiO2"

## Description

### Field of the Invention

This invention relates to a semiconductor memory. More particularly, it relates to a nonvolatile semiconductor memory in which the amount of electric charge controlled by injecting or releasing electric charge in or from a gate insulating film can be retained for a relatively long time even after turn-off of a controlling means, thus having nonvolatile memory effect.

### Description of the Prior Art

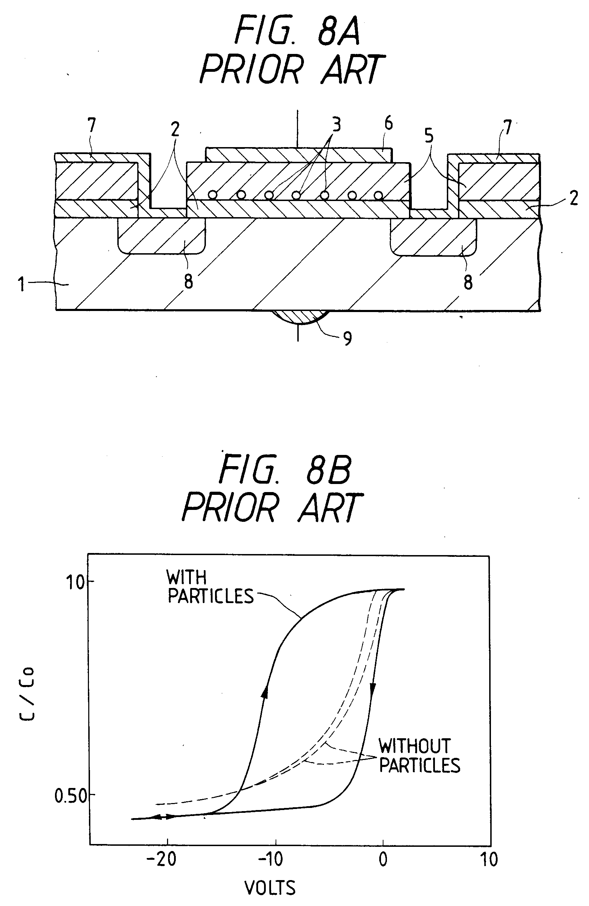

Fig. 8A illustrates an example of a prior art nonvolatile MIS transistor (Japanese Laid-open Patent Application No. 47-6921 of April 15, 1972). An about 3 nm thick SiO₂ film 2 that enables injection and release of electric charge, attributable to tunnel effect, is formed at the top surface of a semiconductor substrate 1, and a plurality of particles 3 with a size of about 3 nm which are scatteringly provided so as to undergo no mutual action (comprising, for example, a semiconductor or a metallic material, specifically including refractory metals such as Mo, and noble metals such as Pt and Ag) are formed by vacuum deposition or the like. Next, an SiO₂ film, Si₃N₄ film or Al₂O₃ film 5 with a thickness of as relatively large as about 75 nm is formed by CVD or the like. The numeral 6 denotes a gate electrode, and 8, a source region or a drain region. The numeral 7 denotes metallic wiring that forms an ohmic contact between the source regions or drain regions, and 9, a substrate contact to the semiconductor substrate 1. As an example in which the insulating films 2 and 5 are formed into a single layer film using the same material, the above Japanese Laid-open Patent Application No. 47-6921 discloses an instance in which metal or semiconductor ions (In⁺ and Nb⁺ are exemplified as suitable ion species) are shot into the interior by ion implantation. This Japanese Laid-open Patent Application No. 47-6921 discloses an example of measurement for an actual nonvolatile memory effect as shown in Fig. 8B. In Fig. 8B, the capacity ratio C/C_{O} standardized to the capacity C_{O} of an insulating film, is indicated as a function of an applied voltage on the gate electrode 6. This actual measurement example is concerned with a gate electrode with two-layer structure comprised of a 25 nm thick SiO₂ film 2 and a 75 nm thick Al₂O₃ film 6, where the particles 3 comprise Pt particles with a nominal size of 3.5 nm, formed by vacuum deposition. When the particles 3 are present, a great hysteresis effect is observed as shown by solid lines. On the other hand, when no particles are present, little hysteresis effect is observed as shown in dotted lines. There, however, is no disclosure as to any example of actual measurement for an instance in which the particles are formed by ion implantation, and it can not be conjectured that a test sample has been prepared. Even if it is conceived that the In⁺ or Nb⁺ ions exemplified in Japanese Laid-open Patent Application No. 47-6921 are implanted in the vicinity of the interface between the insulating films, it is presumed that the implanted ions go through the insulating film and are implanted in the Si substrate, so that the In⁺ or Nb⁺ ions behave as impurities of Group III or Group V ions, respectively, and a great change is caused in the threshold voltage of the MIS transistor.

More specifically, as in the prior art, ions are implanted under Gaussian distribution in order to implant ions so as to have a peak density in the vicinity of about 3 nm from the Si substrate and to give an amount of implantation of approximately from 10¹⁶ to 10¹⁷ cm⁻², so that ions go through an insulating film of about 3 nm thick and implanted in the Si substrate in a dose of approximately from 10¹⁴ to 10¹⁶ cm⁻². Thus, the implantation of a large quantity of Group III or Group V impurities in the Si substrate is presumed to cause a very great change in the threshold voltage, which is as great as several volts or more, thus making it impossible to control the threshold voltage (approximately from 0.5 V to 1.0 V in usual instances) of the MIS transistor. In other words, since the dose of the impurities of Group III or Group V ions, used for controlling of the threshold voltage of the MIS transistor is approximately from 10¹² to 10¹³ cm⁻², it therefore becomes impossible to control the threshold voltage when the In⁺ or Nb⁺ ions are in a larger dose by the factor of one figure to three figures.

Moreover, even if it is attempted to form the peak of ion implantation impurity distribution at the position of about 3 nm from the Si substrate, the non-uniformity of dose of the In⁺ or Nb⁺ ions implanted in the Si substrate is very great when the non-uniformity of the gate electrode or ion implantation energy is taken into account, and also the change in the threshold voltage, caused by In⁺ or Nb⁺ ions, is great. Thus, it becomes impossible to control the threshold voltage of the MIS transistor.

As discussed in the above, the method of forming the particles 3 by the ion implantation conceivable from the prior art can not control the threshold voltage of the MIS transistor, and hence can not be worked as a method of providing a nonvolatile semiconductor memory.

Accordingly, an aim of the present invention is to provide, by the use of ion implantation, a nonvolatile semiconductor memory that enables control of the threshold voltage of an MIS transistor and has a sufficiently large hysteresis, and a method of making the same.

A nonvolatile memory device of this type according to the preamble of present claim 1 is known from IEEE ED-34, 11, p. 2372 (1987).

The present invention provides a nonvolatile semiconductor memory comprising:
a silicon semiconductor substrate;
a gate insulating film formed thereon;
an ion-implanted region formed in said gate insulating film by implantation of Group IV ions at a density of not less than 10¹⁶ cm⁻² such that a peak of impurity density of the ion is present at the gate insulating film side of the interface between said semiconductor substrate and said gate insulating film thereby enabling injection or release of an electric charge to be controlled;
a gate electrode;
a source region; and
a drain region;
characterised in that:
said gate insulating film extends from said source region across said gate to said drain region; and
said ion-implanted region extends across only a part of the width of said gate insulating film.

The present invention, which takes the above constitution, can materialize a nonvolatile semiconductor memory that may contribute no changes in the threshold voltage because of ions that are not activated even when the Group IV ions to be implanted in a gate insulating film are implanted in the Si substrate under Gaussian distribution with its skirt trailed along, and also has a hysteresis well large enough to endure actual use.

Figs. 1A and 1B are views to explain a concept of a gate structure having a nonvolatile memory effect,

Figs. 2A and 2B are graphs to show hysteresis characteristics in actual measurement data showing a nonvolatile memory effect of a gate insulating film.

Figs. 3A to 3D cross-sectionally illustrate a process for the formation of a nonvolatile MOS (metaloxide-semiconductor) memory transistor.

Figs. 4A to 4D and Fig. 5 are graphs to show hysteresis characteristics in actual measurement data showing a nonvolatile memory effect of an MOS transistor.

Fig 6A cross-sectionally illustrates the constitution of an example of the present invention.

Fig. 7 illustrates the circuit constitution of a nonvolatile semiconductor memory according to the present invention.

Fig. 8A cross-sectionally illustrates the constitution of a conventional nonvolatile semiconductor memory, and Fig. 8B is a graph to show the hysteresis characteristics thereof.

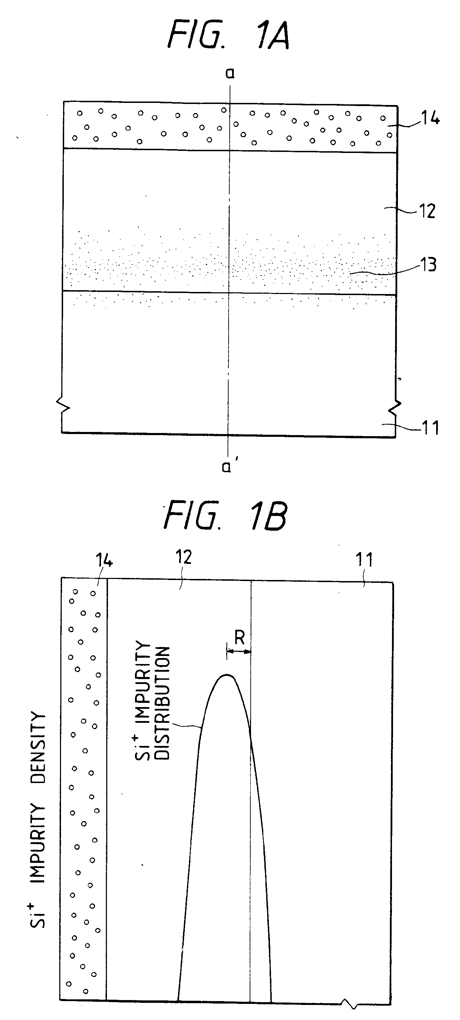

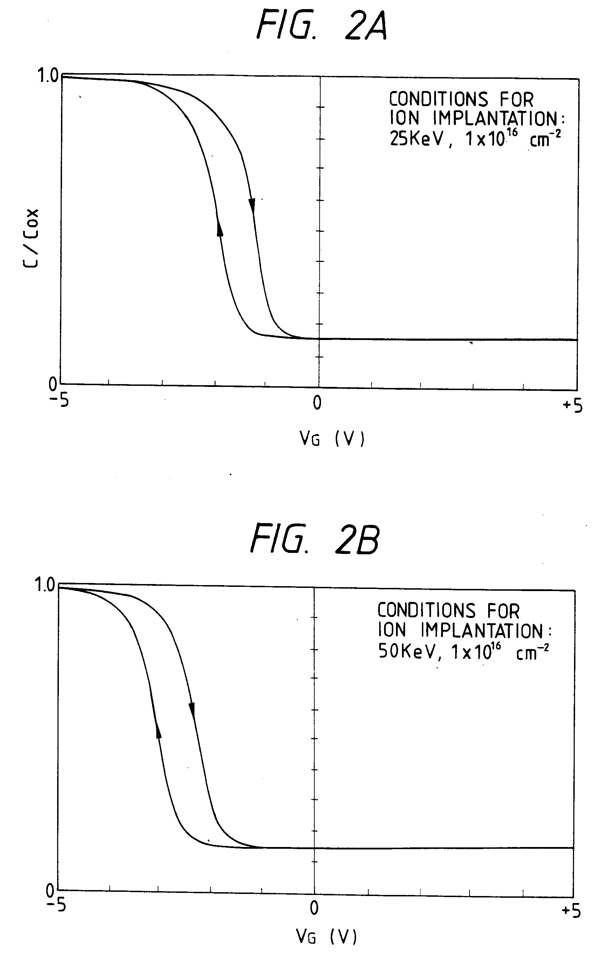

Fig. 1A cross-sectionally illustrate the constitution of a gate region of an MIS transistor, and Fig. 1B illustrate the distribution of impurity density of ion-implanted Si⁺ ions, at a cross section along the line a-a′ in Fig. 1A. On the top surface of a p-type Si substrate 11 with a specific resistance of about 10 Ω·cm, a 50 nm thick SiO₂ film 12 is formed as a gate insulating film. Si⁺ ions are implanted therein at 25 keV or 50 keV in a dose of from 10¹³ to 10¹⁶ cm⁻² to form an Si⁺ ion-implanted regon 13. Thereafter, a polycrystalline Si film 14 is formed as a gate electrode. Here, distance R shown in Fig. 1B (i.e., the distance from the interface between the Si substrate 11 and the SiO₂ film 12, to a peak position of the distribution of impurity density of Si⁺ ions) is about 25 nm when ions are implanted at 25 keV, and about 0 nm, at 50 keV. Figs. 2A and 2B show the dependence of a capacity change ratio (C/C_{OX}, wherein C_{OX} represents a maximum capacity value at an accumulation region) of gate capacity, on a gate voltage V_{G} applied to the gate electrode, in the case when Si⁺ ions are implanted in a dose of 1 x 10¹⁶ cm⁻² and at an implantation energy of 25 keV (Fig. 2A) or 50 keV (Fig. 2B). Hysteresis is observed in the sweep range that V_{G} is ±5 V, giving about 1 V as its window width (amount of change ΔV_{T} of the threshold voltage of an MIS transistor). In the case of a dose of 10¹⁵ cm⁻², the window width of the hysteresis is not more than 0.1 V in the sweep range of ±5 V. In the case of a dose of from 10¹³ to 10¹⁴ cm⁻², no hysteresis phenomenon is observed. In the case when ions are implanted in the dose of 1 x 10¹⁶ cm⁻², the peak impurity densities of Si⁺ ions are about 4.4 x 10²¹ cm⁻³ and about 8.0 x 10²¹ cm⁻³ at 50 keV and 25 keV, respectively, and changes of a flat-band electrode V_{FB} are 0.8 V and 1.9 V, respectively, in spite of the Si⁺ ions implanted in the Si substrate in a high density. In the case of implantation at 50 keV at which the peak of impurity density is presumed to be present at the Si-SiO₂ interface, the V_{FB} change does not exceed 1.9 V. This indicates that greater part of the ions implanted in the dose of 10¹⁶ cm⁻² are inactive and do not contribute the change in V_{FB}, since a theoretical calculation allows a presumption that the Si⁺ ions have been activated only for the ions implanted in the Si substrate in an amount of about 10¹² cm⁻². The validity for the use of Si⁺ ions as in the present invention is thus established. This also corresponds to the fact that there is no change in V_{FB} when Si⁺ ions are implanted in a dose of 10¹⁵ cm⁻² or less at 50 keV or 25 keV, and thus the Si⁺ ions of about 10¹⁵ cm⁻² or so are inactive in the Si substrate.

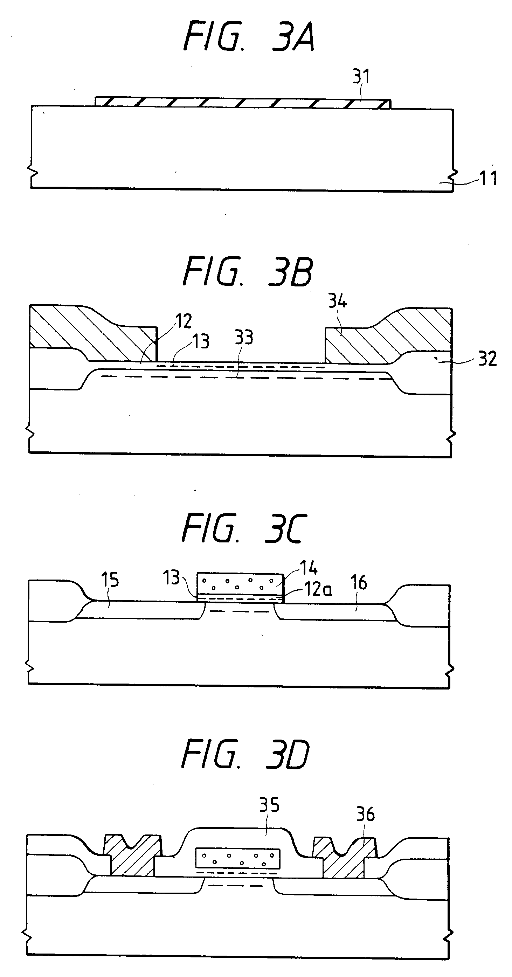

Since the hysteresis phenomenon in the gate insulating film has been prooved, an MOS transistor was then actually manufactured as an experiment, as reported below. Figs. 3A to 3C illustrate a process of the experimental manufacture, and Fig. 3D illustrates a cross-sectional structure of the transistor thus manufactured.

On a p-type Si substrate 11 of about 10 Ω·cm, an Si₃N₄ film 31 is selectively formed (Fig. 3A). Using the resulting Si₃N₄ film 31 as a mask, a field oxide film 32 is formed, and then the Si₃N₄ film 31 is removed (this step is called the LOGOS process). A B⁺ ion-implanted region 33 for controlling the threshold voltage (V_{T}) of the MOS transistor is formed at an implantation energy of 40 keV and in a dose ranging from 4 x 10¹¹ to 10 x 10¹¹ cm⁻². Next, as a gate oxide film, an SiO₂ film 12 is formed with a thickness of 50 nm on the Si substrate 11. A photoresist film 34 is optionally formed, and Si⁺ ions are selectively implanted in the SiO₂ film 12 at an implantation energy of 25 keV or 50 keV in a dose of from 10¹⁵ to 3 x 10¹⁶ cm⁻². An Si⁺ ion-implanted region 13 is thus formed (Fig. 3B). After removal of the photoresist film 34, an n⁺ polycrystalline Si film which contains phosphorus in a high concentration is formed with a thickness of about 350 nm on the whole surface, and a gate electrode 14 and a gate insulating film 12a are selectively formed using a conventional photoetching technique. Thereafter, in the same manner as a process for the manufacture of a conventional Si gate MOS transistor, As⁺ ions are implanted at 80 keV in a dose of 6 x 10¹⁵ cm⁻² using the polycrystalline Si film 14 as a mask for ion implantation, and thus n⁺-diffused regions serving as a source region 15 and a drain region 16 are thus formed. In this instance, a heat treatment for annealing the Si⁺ ion-implanted region 13 in the gate SiO₂ film 12a and the above n⁺-diffused regions 15 and 16 are carried out at 900°C for about 30 minutes (Fig. 3C). Next, as an interlayer insulating film, an interlayer SiO₂ film 35 is formed with a thickness of about 0.8 »m. Contact openings are selectively formed, and aluminum electrodes 36 are formed, thus forming terminals to the source and drain regions or the gate electrode (Fig. 3D).

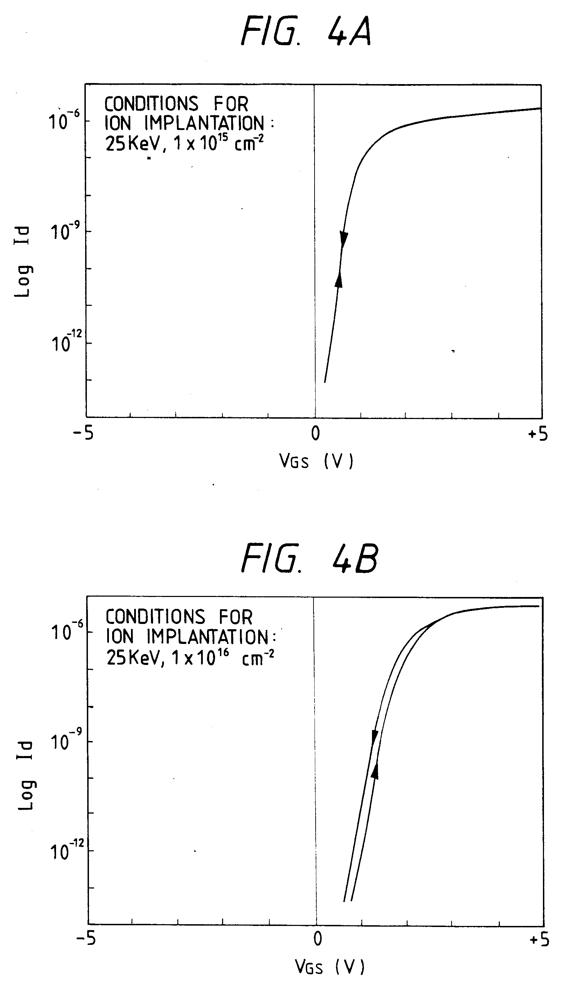

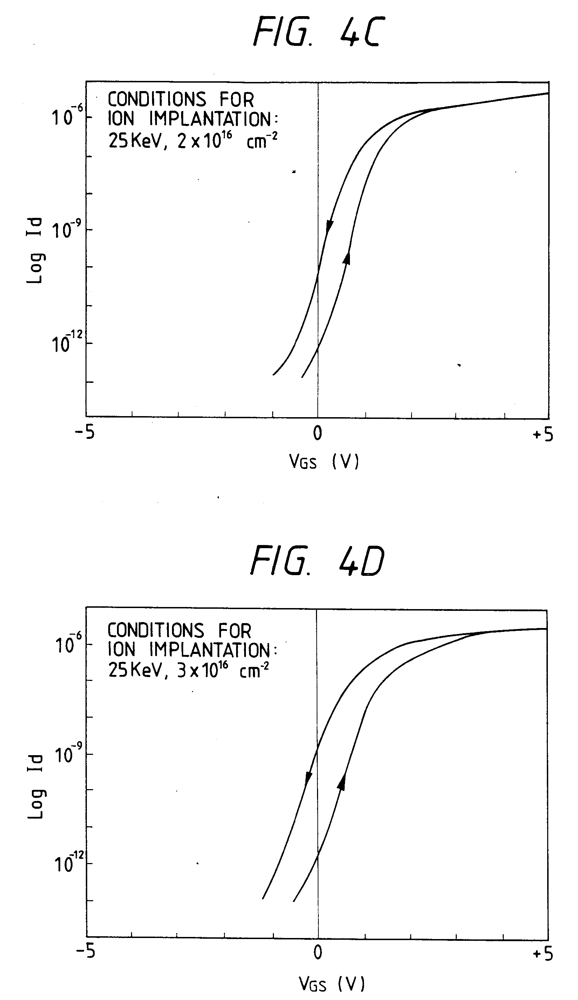

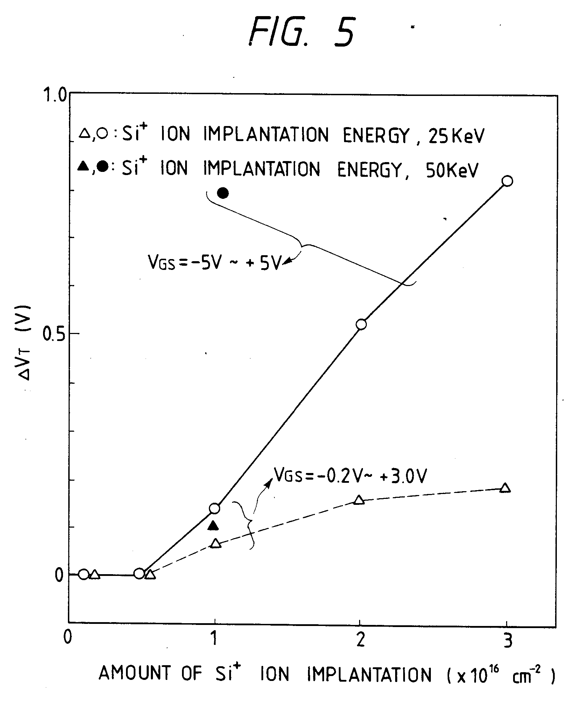

Figs 4A to 4D show characteristics of a drain current Id to a gate-to-source voltage V_{GS} of the MOS transistor when the Si⁺ ion-implanted region 13 is formed under conditions of an implantation energy of 25 keV and in a dose of 1 x 10¹⁵ cm⁻² (Fig. 4A), 1 x 10¹⁶ cm⁻² (Fig. 4B), 2 x 10¹⁶ cm⁻² (Fig. 4C) or 3 x 10¹⁶ cm⁻² (Fig. 4D). In Figs. 4A to 4D, the Id is plotted as ordinate in logarithmic scale. The threshold voltage V_{T} is about 1.0 V, and is substantially constant without regard to the amount of implantation of Si⁺ ions. The voltage V_{SD} between source and drain is 0.1 V, and the substrate bias voltage is 0 V. The gate voltage V_{GS} is in a sweep amplitude of ±5 V. No hysteresis phenomenon is observed when the Si⁺ ions are implanted in a dose of 1 x 10¹⁵ cm⁻², but it begins to be observed when implanted in a dose of 1 x 10¹⁶ cm⁻², and the window width of the hysteresis increases with an increase in the dose of implantation. Fig. 5 shows the relationship between the window width of the hysteresis and the dose of Si⁺ ion implantation. The marks of a triangle and a circle and the marks of a solid triangle and a solid circle indicate data obtained when the ions are implanted at an energy of 25 keV and 50 keV, respectively. The marks of a triangle and a solid triangle and the marks of a circle and a solid circle indicate the cases in which the V_{GS} is in the range of from -0.2 V to +3.0 V, or -5 V to +5V, respectively. When the V_{GS} is in an amplitude of ±5 V, the ΔV_{T} increases substantially in proportion to the amount of Si⁺ ion implantation. When the V_{GS} is in an amplitude of -0.2 V to +3.0 V, up to 0.2 V of ΔV_{T} is obtained at a dose of 3 x 10¹⁶ cm⁻² . In the case of 50 keV, up to 0.8 V of the ΔV_{T} value is obtained in the V_{GS} amplitude of from -5 V to +5 V and up to 0.1 V of the ΔV_{T} value is obtained in the V_{GS} amplitude of from -0.2 V to +3.0 V, when the ions are in a dose of 3 x 10¹⁶ cm⁻². Because of the presence of a peak impurity density at the Si-SiO₂ interface, a large ΔV_{T} value is presumed to have been obtained at a small dose, and it has been found that such Si⁺ ions cause the hysteresis.

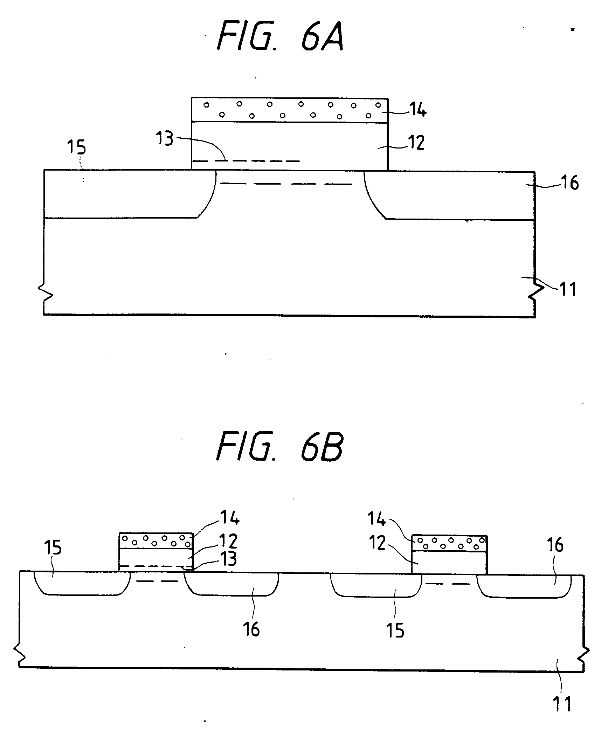

Figs. 6A illustrates an example of the present invention. In Fig. 6A, each numeral correspondingly denotes the constituent member shown in Figs. 3A to 3C.

Fig. 6A shows an instance in which an Si⁺ ion-implanted region 13 is selectively formed at part of a gate insulating film 12. In this instance, the threshold voltage V_{T} of the MOS transistor is determined in a gate insulating film region in which no Si⁺ ions are implanted, so that it becomes possible to more stably control the V_{T} as suited for the MOS transistor.

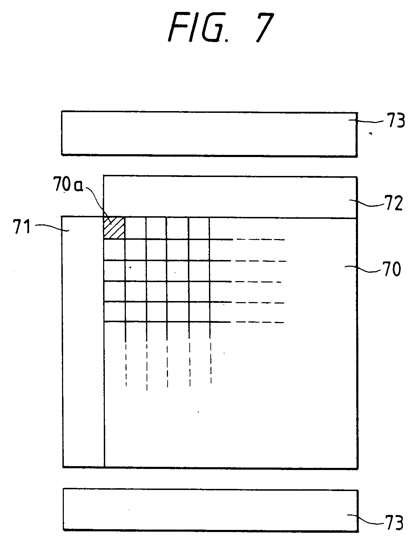

Fig. 6B shows an example in which two types of MOS transistors comprised of a gate insulating film having an Si⁺ ion-implanted region 13 and a gate insulating film having no Si⁺ ion-implanted region 13 are integrally formed on the same Si substrate 11. More specifically, this is an example in which a nonvolatile MOS memory transistor having the nonvolatile memory effect and its peripheral control circuit for controlling the writing and erasing are integrated on the same Si substrate 11. Fig. 7 illustrate a more specific constitution thereof. A plurality of nonvolatile MOS memory transistors 70a having the Si⁺ ion-implanted region, thus having the nonvolatile memory effect, are disposed in array. A line decoder 71 and a string decoder 72, which select a particular device among the transistors 70a disposed in array, are disposed on the periphery of a memory array 70. A peripheral control circuit 73 contains a circuit for controlling the writing and erasing in the memory array 70. In this embodiment, the Si⁺ ion-implanted region is selectively formed only in the nonvolatile MOS memory transistor and no Si⁺ ion-implanted region is formed in the gate oxide film in respect of other decoders 71 and 72 and the peripheral control circuit 73, so that it is possible to achieve more accurate control of threshold voltage.

An example of a method of controlling an actual nonvolatile MOS memory transistor is described below. For example, at the time of writing, a high voltage of +5 V or more is applied to the Si⁺ ion-implanted region so that a signal charge is written in the Si⁺ ion-implanted region so as to give a high threshold voltage. At the time of erasing, a voltage of about -5V may be applied to the gate electrode so as to give a low threshold voltage. When a signal is read out, a read-out voltage with a voltage slightly higher than the threshold voltage of the nonvolatile MOS memory transistor in which no signal charge is accumulated is applied so as not to bring about a break of the signal charge stored in the Si⁺ ion-implanted region. No drain current flows in the MOS memory transistor with a high threshold voltage, in which the signal charge is accumulated, but the drain current flows in the MOS memory transistor with a low threshold voltage, in which no signal charge is accumulated. The written signal can be read out depending on whether or not this drain current flows.

Thus, the nonvolatile MOS memory transistor according to the present invention can write/erase signals depending on the voltage applied to the gate electrode or the source/drain, and hence is useful as the so-called programable ROM (E²PROM) capable of being electrically written and erased.

The memory retension characteristics of the nonvolatile MOS memory transistor obtained in the present experiment lasts for a longer period with an increase in the write voltage, and shows retension characteristics of from one month to several years.

As having been described above, in the present invention, the ion belonging to the same Group IV in the periodic table as the ion of an Si substrate belongs is implanted in the gate insulating film. As a result, the hysteresis phenomenon that may not adversely affect the threshold voltage and also occurs at a gate voltage as low as ±5 V has been established in the nonvolatile MOS memory transistor actually manufactured as an experiment. In the examples of the present invention, Si⁺ ions are implanted. It, however, can be readily presumed that the same effect can be promised when Ge⁺ ions, Sn⁺ ions or Pb⁺ ions are implanted.

Thus, the present invention can materialize a nonvolatile semiconductor memory by virtue of the simple operation that the Si⁺ ions or the like are implanted in the gate insulating film. At the same time, MOS transistors used for a peripheral control circuit in which a more stable control of threshold voltage is required can be readily integrated on the same substrate by selectively forming the Si⁺ ion-implanted region only in a nonvolatile semiconductor memory.

## Claims

1. A nonvolatile semiconductor memory comprising:
a silicon semiconductor substrate (11);
a gate insulating film (12) formed thereon;
an ion-implanted region (13) formed in said gate insulating film by implantation of Group IV ions at a density of not less than 10¹⁶ cm⁻² such that a peak of impurity density of the ion is present at the gate insulating film side of the interface between said semiconductor substrate and said gate insulating film thereby enabling injection or release of an electric charge to be controlled;
a gate electrode (14);
a source region (15); and
a drain region (16);
characterised in that:
said gate insulating film extends from said source region across said gate to said drain region; and
said ion-implanted region extends across only a part of the width of said gate insulating film.

2. A nonvolatile semiconductor memory according to claim 1, wherein an Si⁺ ion is used as said ion of Group IV.

3. A method of manufacturing a nonvolatile semiconductor memory according to any one of the previous claims, comprising the steps of forming a gate insulating film on a silicon semiconductor substrate, implanting a Group IV ion in said gate insulating film at a density of not less than 10¹⁶ cm⁻² such that a peak of impurity density of the ion is present at the gate insulating film side of the interface between said semiconductor substrate and said gate insulating film to form an ion-implanted region, and forming a gate electrode, a source region, and a drain region, characterised in that said gate insulating film is formed to extend between said source and drain regions; and said ion implanted region is formed to extend across only a part of the width of said gate insulating field.

4. A method of manufacturing a nonvolatile semiconductor memory according to claim 3, wherein an Si⁺ ion is used as said Group IV ion.

## Patentansprüche

1. Permanenter Halbleiter-Speicher, umfassend:
ein Silizium-Halbleitersubstrat (11);
einen auf dem Silizium-Halbleitersubstrat gebildeten Gate-Isolierfilm (12);
einen ionenimplantierten Bereich (13), der in dem Gate-Isolierfilm durch Implantation von Ionen der Gruppe IV bei einer Dichte von nicht weniger als 10¹⁶ cm⁻² gebildet ist, so daß ein Spitzenwert der Verunreinigungsdichte des Ions an der Gate-Isolierfilmseite der Grenzfläche zwischen dem Halbleiter-Substrat und dem Gate-Isolierfilm vorhanden ist, wodurch die Injektion oder die Freisetzung einer zu steuernden elektrischen Ladung ermöglicht wird;
eine Gate-Elektrode (14);
einen Source-Bereich (15); und
einen Drain-Bereich (16);
dadurch gekennzeichnet, daß:
sich der Gate-Isolierfilm von dem Source-Bereich über das Gate zu dem Drain-Bereich erstreckt; und
sich der ionenimplantierte Bereich über nur einen Teil der Breite des Gate-Isolierfilms erstreckt.

2. Permanenter Halbleiterspeicher nach Anspruch 1, wobei ein Si⁺-Ion als das Ion der Gruppe IV verwendet wird.

3. Verfahren zur Herstellung eines permanenten Halbleiterspeichers nach einem der vorhergehenden Ansprüche, umfassend die Schritte zur Bildung eines Gate-Tsolierfilms auf einem Silizium-Halbleitersubstrat, Implantieren eines Ions der Gruppe IV in dem Gate-Isolierfilm bei einer Dichte von nicht weniger als 10¹⁶ cm⁻², so daß ein Spitzenwert der Verunreinigungsdichte des Ions an der Gate-Isolierfilmseite der Grenzfläche zwischen dem Halbleiter-Substrat und dem Gate-Isolierfilm vorhanden ist, unter Bildung eines ionenimplantierten Bereichs, und zur Bildung einer Gate-Elektrode, eines Source-Bereichs und eines Drain-Bereichs, dadurch gekennzeichnet, daß der Gate-Isolierfilm gebildet wird, so daß er sich zwischen dem Source- und Drain-Bereich erstreckt; und der ionenimplantierte Bereich gebildet wird, so daß er sich über nur einen Teil der Breite des Gate-Isolierfelds erstreckt.

4. Verfahren zur Herstellung eines permanenten Halbleiterspeichers nach Anspruch 3, wobei ein Si⁺-Ion als das Ion der Gruppe IV verwendet wird.

## Revendications

1. Mémoire à semi-conducteur non volatile, qui comprend :
- un substrat (11) de silicium semi-conducteur,
- un film isolant de grille (12) formé sur celui-ci,
- une région d'implantation ionique (13) formée dans ledit film isolant de grille par implantation d'ions du groupe IV avec une densité non inférieure à 10¹⁶ cm⁻² de telle sorte qu'il y ait un pic de densité d'impuretés ioniques au niveau du film isolant de grille, du côté de l'interface entre ledit substrat semi-conducteur et ledit film isolant de grille, ce qui permet de commander une injection ou une libération de charge électrique,
- une électrode de grille (14),
- une région formant source (15), et
- une région formant drain (16),
caractérisée en ce que :
- ledit film isolant de grille s'étend depuis ladite région formant source, à travers ladite grille et jusqu'à ladite région formant drain, et
- ladite région d'implantation ionique s'étend sur une partie seulement de la largeur dudit film isolant de grille.

2. Mémoire à semi-conducteur non volatile selon la revendication 1, dans laquelle un ion Si⁺ est utilisé en tant que ledit ion du groupe IV.

3. Procédé de fabrication d'une mémoire à semi-conducteur non volatile conforme à l'une quelconque des précédentes revendications, comprenant les étapes consistant à former un film isolant de grille sur un substrat de silicium semi-conducteur, à implanter un ion du groupe IV dans ledit film isolant de grille à une densité non inférieure à 10¹⁶ cm⁻² de telle sorte qu'il y ait un pic de densité d'impuretés ioniques au niveau du film isolant de grille, du côté de l'interface entre ledit substrat semi-conducteur et ledit film isolant de grille, et à former une électrode de grille, une région formant source et une région formant drain,
caractérisé en ce que ledit film isolant de grille est formé pour s'étendre entre lesdites régions formant source et formant drain, et ladite région d'implantation ionique est formée pour s'étendre sur une partie seulement de la largeur dudit film isolant de grille.

4. Procédé de fabrication d'une mémoire à semi-conducteur non volatile selon la revendication 3, dans lequel un ion Si⁺ est utilisé en tant que ledit ion du groupe IV.
